# EUROPEAN PATENT APPLICATION

(11) **EP 4 451 319 A2**
(43) Date of publication of application: **23.10.2024**
(21) Application number: 24166350.9
(22) Date of filing: 26.03.2024
(51) Int. Cl.: H01L 21/822, H01L 21/8234, H01L 27/06, H01L 27/088, H01L 29/06, H01L 29/66, H01L 29/775, H01L 29/786

(54) **INTEGRATED CIRCUIT DEVICES INCLUDING STACKED TRANSISTORS AND METHODS OF FORMING THE SAME**

(30) Priority: 19.04.2023 US 202363497009 P; 28.08.2023 US 202318456571
(71) Applicant: Samsung Electronics Co., Ltd., Suwon-si, Gyeonggi-do 16677 (KR)
(72) Inventor: SONG, Seung Min, San Jose, CA 95134 (US); PARK, Panjae, San Jose, CA 95134 (US); SEO, Kang-Ill, San Jose, CA 95134 (US)
(74) Representative: Kuhnen & Wacker Patent- und Rechtsanwaltsbüro PartG mbB

(57) **Abstract**

Integrated circuit devices may include an upper transistor structure on a substrate, the upper transistor structure comprising an upper channel region and an upper gate electrode on the upper channel region; a lower transistor structure between the substrate and the upper transistor structure, the lower transistor structure comprising a lower channel region and a lower gate electrode on the lower channel region; and an intergate contact between the lower gate electrode and the upper gate electrode. The lower gate electrode may be electrically connected to the upper gate electrode through the intergate contact, and a portion of a lower surface of the intergate contact may protrude beyond a side surface of the lower gate electrode.

## Description

### BACKGROUND

The present disclosure generally relates to the field of integrated circuit devices and, more particularly, to three-dimensional integrated circuit devices that include stacked transistors.

Various structures of an integrated circuit device including stacked transistors and methods of forming the same have been proposed to increase the integration density of the integrated circuit device while securing an electrical connection between conductive elements.

### SUMMARY

An integrated circuit device according to some embodiments may include an upper transistor structure on a substrate, the upper transistor structure comprising an upper channel region and an upper gate electrode on the upper channel region; a lower transistor structure between the substrate and the upper transistor structure, the lower transistor structure comprising a lower channel region and a lower gate electrode on the lower channel region; and an intergate contact between the lower gate electrode and the upper gate electrode. The lower gate electrode may be electrically connected to the upper gate electrode through the intergate contact, and a portion of a lower surface of the intergate contact may protrude beyond a side surface of the lower gate electrode.

An integrated circuit device according to some embodiments may include an upper transistor structure on a substrate, the upper transistor structure comprising an upper channel region and an upper gate electrode on the upper channel region; a lower transistor structure between the substrate and the upper transistor structure, the lower transistor structure comprising a lower channel region and a lower gate electrode on the lower channel region; and an intergate contact between the lower gate electrode and the upper gate electrode. The lower channel region and the upper channel region may be spaced apart from each other in a vertical direction, and an upper surface of the intergate contact may have a third width in a horizontal direction, and the third width may be wider than a fourth width of an interface between the intergate contact and the upper gate electrode in the horizontal direction.

A method of forming an integrated circuit device according to some embodiments may include forming a preliminary lower transistor structure on a substrate, the preliminary lower transistor structure comprises: a lower channel region; two preliminary lower gate spacers that are spaced apart from each other in a horizontal direction and are on the lower channel region; a preliminary lower gate electrode that is between the two preliminary lower gate spacers and is on the lower channel region; and a lower gate capping layer that is between the two preliminary lower gate spacers and is on the preliminary lower gate electrode; forming a first insulating layer on the substrate, wherein the preliminary lower transistor structure is in the first insulating layer; removing the lower gate capping layer and respective upper portions of the two preliminary lower gate spacers, thereby forming a contact opening in the first insulating layer on the preliminary lower gate electrode; forming a preliminary intergate contact in the contact opening; forming an intergate insulator on the preliminary intergate contact; and forming an upper transistor structure on the intergate insulator, the upper transistor structure comprising an upper channel region and an upper gate electrode on the upper channel region. The upper gate electrode may extend through the intergate insulator.

### BRIEF DESCRIPTION OF THE DRAWINGS

FIG. 1 is a layout of an integrated circuit device according to some embodiments.
FIG. 2A is a cross-sectional view of a first integrated circuit device taken along the line A-A' in FIG. 1 according to some embodiments, and FIG. 2B is an enlarged view of the region R in FIG. 2A.
FIG. 3 is a cross-sectional view of a second integrated circuit device taken along the line A-A' in FIG. 1 according to some embodiments.
FIG. 4 is a cross-sectional view of a third integrated circuit device taken along the line A-A' in FIG. 1 according to some embodiments.
FIG. 5 is a flow chart of a method of forming an integrated circuit device according to some embodiments.
FIGS. 6 through 15 are cross-sectional views illustrating a method of forming an integrated circuit device according to some embodiments.
FIGS. 16 through 20 are cross-sectional views illustrating a method of forming an integrated circuit device according to some embodiments.

### DETAILED DESCRIPTION

An integrated circuit device including stacked transistors may include an upper gate electrode and a lower gate electrode. An electrical connection between those upper and lower gate electrodes may be desirable in some areas. When the upper and lower gate electrodes are formed separately using separate mask patterns and/or widths of the upper and lower gate electrodes are narrow, a misalignment between the upper and lower gate electrodes can occur. The misalignment between the upper and lower gate electrodes may reduce an interface area between the upper and lower gate electrodes and thus may increase an interface resistance.

According to some embodiments, an intergate contact having a width wider than widths of upper and lower gate electrodes are provided, and the intergate contact may contact an entirety of a lower surface of the upper gate electrode and/or an entirety of an upper surface of the lower gate electrode even when there is a misalignment between the upper and lower gate electrodes. Accordingly, an interface resistance may not increase despite the misalignment between the upper and lower gate electrodes.

Example embodiments will be described in greater detail with reference to the attached figures.

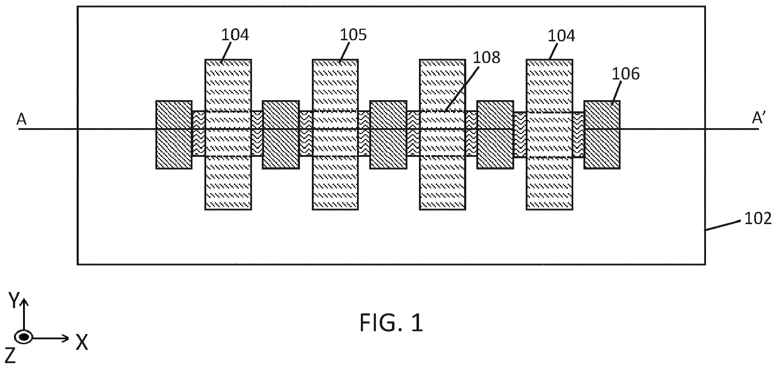

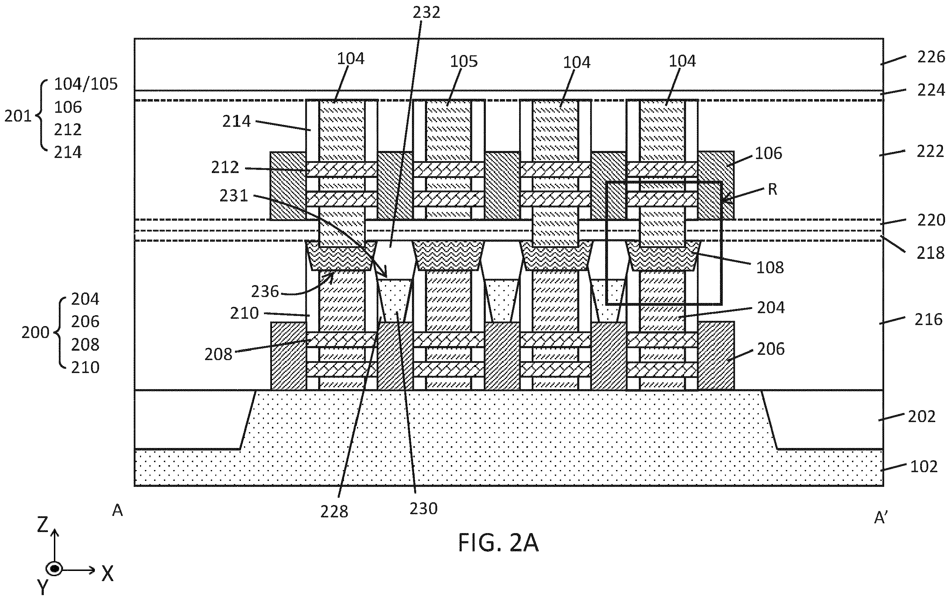

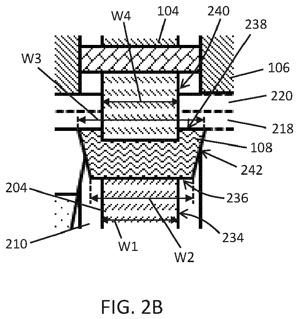

FIG. 1 is a layout of an integrated circuit device according to some embodiments. FIG. 2A is a cross-sectional view of a first integrated circuit device taken along the line A-A' in FIG. 1 according to some embodiments, and FIG. 2B is an enlarged view of the region R in FIG. 2A.

Referring to FIGS. 1 and 2A, the first integrated circuit device may include transistor stacks provided on a substrate 102. Each of the transistor stacks may include a lower transistor structure 200 and an upper transistor structure 201. The lower transistor structure 200 may be between the substrate 102 and the upper transistor structure 201. Specifically, the transistor stacks may be provided on a portion of the substrate 102 defined by a device isolation layer 202. In some embodiments, an upper surface of the substrate 102 may be coplanar with an upper surface of the device isolation layer 202, as illustrated in FIG. 2A. The upper surface of the substrate 102 faces the transistor stacks, and the substrate 102 may further include a lower surface opposite the upper surface thereof.

The transistor stacks may be spaced apart from each other in a first direction X (also referred to as a first horizontal direction). The first direction X may be parallel to the upper surface of the substrate 102 and/or the lower surface of the substrate 102.

The lower transistor structure 200 may include a lower gate electrode 204, a lower source/drain region 206 adjacent to a side surface of the lower gate electrode 204, a lower channel region 208 contacting the lower source/drain region 206 (e.g., a side surface of the lower source/drain region 206), and a lower gate spacer 210 (also referred to as a lower inner gate spacer) between the lower gate electrode 204 and the lower source/drain region 206. In some embodiments, the lower transistor structure 200 may include multiple lower channel regions 208 that are stacked in a third direction Z (also referred to as a vertical direction) and are spaced apart from each other in the third direction Z. Although FIG. 2A illustrates that the lower transistor structure 200 includes two lower channel regions 208, in some embodiments, the lower transistor structure 200 may include three or more lower channel regions 208. The third direction Z may be perpendicular to the first direction X and/or the second direction Y.

Although not explicitly illustrated in FIG. 2A, a lower gate insulator may extend between the lower channel region 208 and the lower gate electrode 204 and may separate the lower channel region 208 from the lower gate electrode 204. Additionally, a lower interfacial layer that extends between the lower channel region 208 and the lower gate insulator may be provided.

The upper transistor structure 201 may include first and second upper gate electrodes 104 and 105, an upper source/drain region 106 adjacent to a side surface of the first or second upper gate electrodes 104 or 105, an upper channel region 212 contacting the upper source/drain region 106 (e.g., a side surface of the upper source/drain region 106), and an upper gate spacer 214 (also referred to as an upper inner gate spacer) between the first or second upper gate electrodes 104 or 105 and the upper source/drain region 106. Each of the first and second upper gate electrodes 104 and 105 may extend longitudinal in a second direction Y (also referred to as a second horizontal direction). The second direction Y may be parallel to the upper surface of the substrate 102 and/or the lower surface of the substrate 102. In some embodiments, the second direction Y may be perpendicular to the first direction X. In some embodiments, the upper transistor structure 201 may include multiple upper channel regions 212 that are stacked in the third direction Z and are spaced apart from each other in the third direction Z. Although FIG. 2A illustrates that the upper transistor structure 201 includes two upper channel regions 212, in some embodiments, the upper transistor structure 201 may include three or more upper channel regions 212.

Although not explicitly illustrated in FIG. 2A, an upper gate insulator may extend between the upper channel region 212 and the first or second upper gate electrodes 104 or 105 and may separate the upper channel region 212 from the first or second upper gate electrodes 104 or 105. Additionally, an upper interfacial layer that extends between the upper channel region 212 and the upper gate insulator may be provided.

The upper channel region 212 and the lower channel region 208 may be spaced apart from each other in the third direction Z and may overlap each other in the third direction Z. The first or second upper gate electrodes 104 or 105 and the lower gate electrode 204 may be spaced apart from each other in the third direction Z and may overlap each other in the third direction Z. The lower gate electrode 204 may have a shape the same as or similar to the first or second upper gate electrodes 104 or 105 in plan view and may extend longitudinally in the third direction Z. The upper source/drain region 106 and the lower source/drain region 206 may be spaced apart from each other in the third direction Z and may overlap each other in the third direction Z. As used herein, "an element A overlapping an element B in a direction X" (or similar language) means that there is at least one line that extends in the direction X and intersects both the elements A and B.

In some embodiments, each of the lower transistor structure 200 and the upper transistor structure 201 may have a structure different from that illustrated in FIG. 2A. For example, each of the lower transistor structure 200 and the upper transistor structure 201 may be a gate-all-around (GAA) transistor including a single channel region or a fin-shaped field-effect transistor (FinFET).

An intergate contact 108 may be provided between the lower gate electrode 204 and the first or second upper gate electrodes 104 or 105. The intergate contact 108 may overlap with the lower gate electrode 204 and the first or second upper gate electrodes 104 or 105 in the third direction Z (also referred to as a vertical direction). The lower gate electrode 204 may be electrically connected to the upper gate electrode 104 through the intergate contact 108. In some embodiments, the intergate contact 108 may contact a lower surface of the first upper gate electrode 104 and an upper surface of the lower gate electrode 204, as illustrated in FIG. 2A. Although FIG. 2A illustrates that an upper surface of the intergate contact 108 includes a recess and a lower portion of the first upper gate electrode 104 is in that recess, in some embodiments, the upper surface of the intergate contact 108 may not include any recess, and the first upper gate electrode 104 may not include any portion that is in the intergate contact 108. The second upper gate electrode 105 may be spaced apart from the intergate contact 108 in the third direction Z, as illustrated in FIG. 2A.

In some embodiments, multiple intergate contacts 108 may be provided and the first and second upper gate electrodes 104 and 105 may overlap respective intergate contacts 108 in the third direction Z, as illustrated in FIG. 2A. In some other embodiment, however, the intergate contact 108 overlapped with the second upper gate electrode 105 may be omitted, and the second upper gate electrode 105 may not overlap any of the intergate contacts 108 in the third direction Z.

The lower transistor structure 200 and the intergate contact 108 may be provided in a first insulating layer 216 provided on the substrate 102. A second insulating layer 218, a third insulating layer 220, a fourth insulating layer 222 and a fifth insulating layer 224 may be sequentially provided on the first insulating layer 216. A lower portion of the upper gate electrode 104 may extend through the second insulating layer 218 and the third insulating layer 220 in the third direction Z and may contact the intergate contact 108. Portions of the second insulating layer 218 and the third insulating layer 220 may be provided between the second upper gate electrode 105 and the intergate contact 108 that overlaps with the second upper gate electrode 105 in the third direction Z. The second insulating layer 218 and the third insulating layer 220 may be collectively referred to as an intergate insulator. In some embodiments, the intergate insulator may be a single layer (e.g., a monolithic layer). Interfaces (represented by dotted lines in FIG. 2A) between the first, second, third, fourth and fifth insulating layers 216, 218, 220, 222 and 224 may not be visible.

An upper structure 226 may be provided on the fifth insulating layer 224. The upper structure 226 may include elements formed by the middle-of-line (MOL) portion and/or the back-end-of-line (BEOL) portion of device fabrication. The upper structure 226 may include and insulating elements (e.g., interlayer insulating layer(s) and/or spacer(s)) and conductive elements (e.g., wire(s) or via plug(s)).

A source/drain contact 230 may be provided between two adjacent lower transistor structures 200 and may contact the lower source/drain region 206. A sixth insulating layer 228 may be provided between the source/drain contact 230 and the lower gate spacer 210, and a seventh insulating layer 232 may be provided on the source/drain contact 230 between two adjacent intergate contacts 108. In some embodiments, an upper surface 231 of the source/drain contact 230 may be closer than a lower surface 236 of the intergate contact 108 to the substrate 102, as illustrated in FIG. 2A.

The substrate 102 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the substrate 102 may be a bulk substrate (e.g., a bulk silicon substrate), a semiconductor on insulator (SOI) substrate or an insulating layer (e.g., a monolithic insulating layer). For example, the substrate 102 may be a silicon wafer. The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

Each of the device isolation layer 202 and the first, second, third, fourth, fifth, sixth and seventh insulating layers 216, 218, 220, 222, 224, 228 and 232 may include independently insulating material(s) (e.g., silicon oxide, silicon oxynitride, silicon nitride, silicon carbonitride and/or a low-k material). Each of the device isolation layer 202 and the first, second, third, fourth, fifth, sixth and seventh insulating layers 216, 218, 220, 222, 224, 228 and 232 may be a single layer or multiple layers stacked on the substrate 102.

Each of the intergate contact 108, the lower gate electrode 204, the first and second upper gate electrodes 104 and 105, and the source/drain contact 230 may include a single layer or multiple layers. In some embodiments, each of the intergate contact 108, the lower gate electrode 204, the first and second upper gate electrodes 104 and 105, and the source/drain contact 230 may include metallic layer(s) that include, for example, tungsten (W), aluminum (Al), copper (Cu), molybdenum (Mo) and/or ruthenium (Ru). The lower gate electrode 204, the first and second upper gate electrodes 104 and 105 may additionally include work function layer(s) (e.g., a TiN layer, a TaN layer, a TiAl layer, a TiC layer, a TiAlC layer, a TiAlN layer and/or a WN layer). In some embodiments, the intergate contact 108, the lower gate electrode 204 and first and second upper gate electrodes 104 and 105 may include the same material(s). In some other embodiments, the intergate contact 108 may include material(s) different from the lower gate electrode 204 and/or first and second upper gate electrodes 104 and 105. Work function layer(s) may be provided between the metallic layer(s) of a gate electrode (e.g., the lower gate electrode 204 or first or second upper gate electrodes 104 or 105) and a channel region (e.g., the lower channel region 208 or the upper channel region 212). In some embodiments, the work function layer(s) may separate the metallic layer(s) from a gate insulator (e.g., the lower gate insulator or the upper gate insulator).

Each of the lower channel region 208 and the upper channel region 212 may include independently, for example, semiconductor material(s) (e.g., Si, Ge, SiGe, GaP, GaAs, SiC, SiGeC and/or InP). In some embodiments, the lower channel region 208 and the upper channel region 212 may include the same material(s). In some embodiments, each of the lower channel region 208 and the upper channel region 212 may be a nanosheet that may have a thickness in a range of from 1 nm to 100 nm in the third direction Z or may be a nanowire that may have a circular cross-section with a diameter in a range of from 1 nm to 100 nm.

Each of the lower source/drain region 206 and the upper source/drain region 106 may include independently, for example, semiconductor layer(s) (e.g., a silicon layer and/or a silicon germanium layer) and may additionally include dopants in the semiconductor layer(s). In some embodiments, each of the lower source/drain region 206 and the upper source/drain region 106 may include metal layer(s) that include, for example, W, Al, Cu, Mo and/or Ru.

Each of the lower gate spacer 210 and the upper gate spacer 214 may include, for example, silicon oxide, silicon oxynitride, silicon nitride, silicon carbonitride and/or a low-k material. In some embodiments, the lower gate spacer 210 and the upper gate spacer 214 may include the same material(s).

Referring to FIG. 2B, the lower gate spacer 210 may be provided on (e.g., may contact) a side surface 234 of the lower gate electrode 204. The intergate contact 108 may include a lower surface 236 and an upper surface 238 opposite the lower surface 236. The lower surface 236 of the intergate contact 108 may contact the lower gate electrode 204 (e.g., an upper surface of the lower gate electrode 204), and the upper surface 238 of the intergate contact 108 may contact the upper gate electrode 104 (e.g., a lower surface of the upper gate electrode 104). In some embodiments, a portion of the lower surface 234 of the intergate contact 108 may protrude beyond the side surface 234 of the lower gate electrode 204 in the first direction X. In some embodiments, a portion of the upper surface 238 of the intergate contact 108 may protrude beyond a side surface 240 of the upper gate electrode 104 in the first direction X. In some embodiments, the upper gate electrode 104 may not overlap an edge portion of the upper surface 238 of the intergate contact 108 in the third direction Z, as illustrated in FIG. 2B. The edge portion of the upper surface 238 of the intergate contact 108 may contact the second insulating layer 218 that is a portion of the intergate insulator.

The upper surface of the lower gate electrode 204 may have a first width W1 in the first direction X, the lower surface 236 of the intergate contact 108 may have a second width W2 in the first direction X, and the first width W1 may be narrower than the second width W2. The upper surface 238 of the intergate contact 108 may have a third width W3 in the first direction X, the lower surface of the upper gate electrode 104 may have a fourth width W4 in the first direction X, and the third width W3 may be wider than the fourth width W4. In some embodiments, the third width W3 may be wider than the second width W2. In some embodiments, a width of the intergate contact 108 in the first direction X may increase with increasing distance from the substrate 102 in the third direction Z.

Still referring to FIG. 2B, a portion of the lower surface 236 of the intergate contact 108 may contact the lower gate spacer 210, and a portion (e.g., a lower portion) of a side surface 242 of the intergate contact 108 may contact the lower gate spacer 210. In some embodiments, the side surface 234 of the lower gate electrode 204 and the side surface 240 of the upper gate electrode 104 may be aligned with each other along the third direction Z, as illustrated in FIG. 2B.

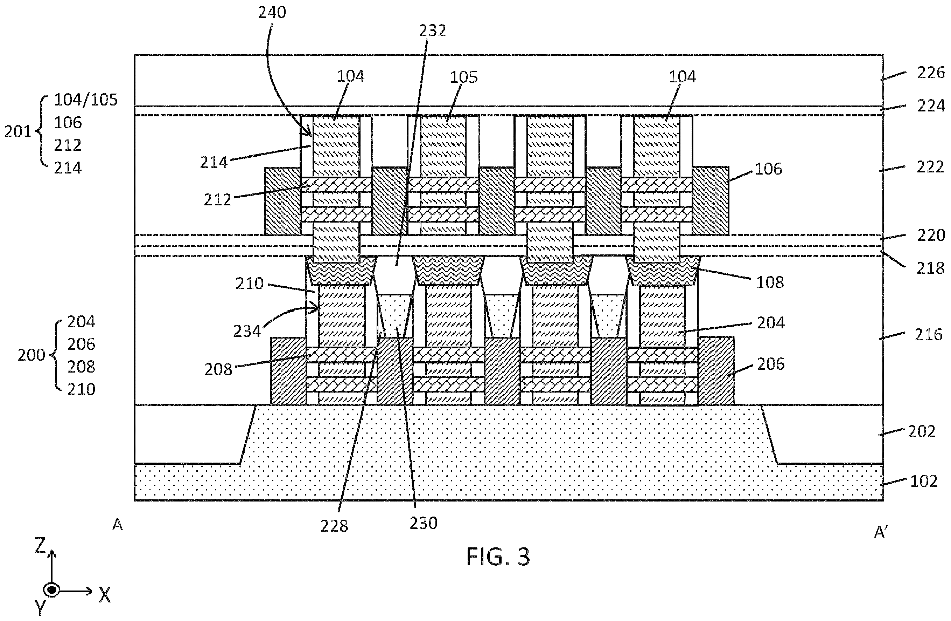

FIG. 3 is a cross-sectional view of a second integrated circuit device taken along the line A-A' in FIG. 1 according to some embodiments. The second integrated circuit device illustrated in FIG. 3 may be similar to the first integrated circuit device illustrated in FIG. 1 with the primary difference being that the side surface 234 of the lower gate electrode 204 and the side surface 240 of the upper gate electrode 104 may be offset from each other in the first direction X. As illustrated in FIG. 3, according to some embodiments, an entirety of a lower surface of the upper gate electrode 104 may contact a conductive element (i.e., the intergate contact 108) despite misalignment between the lower gate electrode 204 and the upper gate electrode 104.

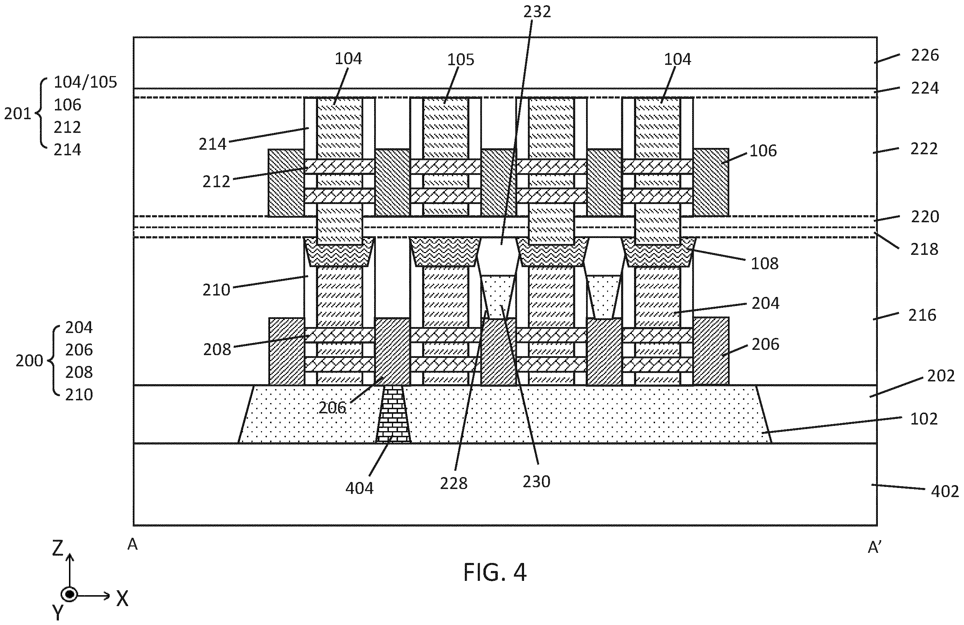

FIG. 4 is a cross-sectional view of a third integrated circuit device taken along the line A-A' in FIG. 1 according to some embodiments. The third integrated circuit device illustrated in FIG. 4 may be similar to the first integrated circuit device illustrated in FIG. 1 with the primary difference being that a backside power distribution network structure (BSPDNS) 402 may be provided on the lower surface of the substrate 102, and at least one lower source/drain region 206 may be electrically connected to the BSPDNS 402 through a backside contact 404 provided in the substrate 102. The BSPDNS structure 402 may include conductive elements (e.g., power line(s) and/or or power via(s)) and insulating elements (e.g., interlayer insulating layer(s) or spacer(s)). At least one of the conductive elements of the BSPDNS structure 402 may be electrically connected to, for example, at least one lower source/drain region 206.

The backside contact 404 may include a single layer or multiple layers. In some embodiments, the backside contact 404 may include metallic layer(s) that includes, for example, W, Al, Cu, Mo and/or Ru.

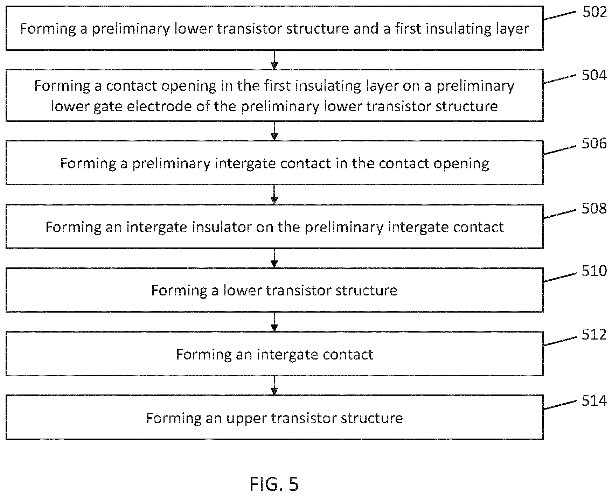

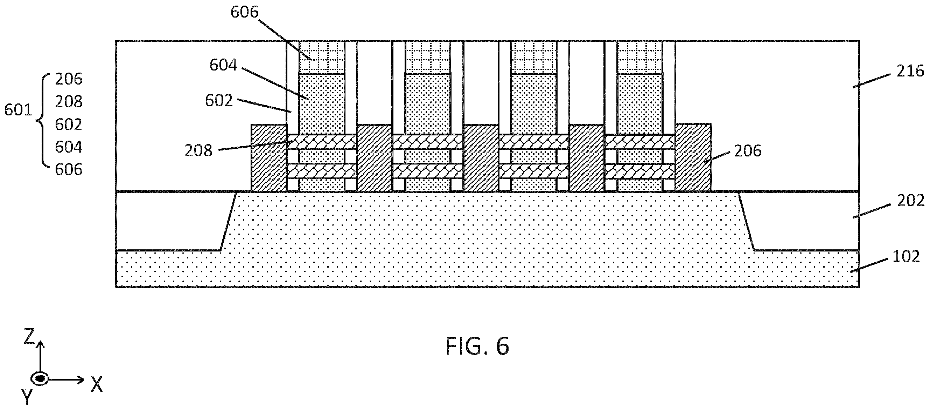

FIG. 5 is a flow chart of a method of forming an integrated circuit device according to some embodiments. FIGS. 6 through 15 are cross-sectional views illustrating a method of forming an integrated circuit device according to some embodiments.

Referring to FIGS. 5 and 6, the method may include forming a preliminary lower transistor structure 601 and a first insulating layer 216 on a substrate 102 (Block 502). In some embodiments, multiple preliminary lower transistor structures 601 may be formed on a portion of the substrate 102 defined by a device isolation layer 202, as illustrated in FIG. 6. The preliminary lower transistor structures 601 may be spaced apart from each other in a first direction X. The preliminary lower transistor structure 601 may be provided in the first insulating layer 216.

The preliminary lower transistor structure 601 may include a lower channel region 208, a preliminary lower gate spacer 602 on the lower channel region 208, a preliminary lower gate electrode 604 on the lower channel region 208, a lower gate capping layer 606 on the preliminary lower gate electrode 604, and a lower source/drain region 206 adjacent to a side surface of the preliminary lower gate electrode 604. The preliminary lower transistor structure 601 may include two preliminary lower gate spacers 602 that are spaced apart from each other in the first direction X, and both the preliminary lower gate electrode 604 and the lower gate capping layer 606 may be between those two preliminary lower gate spacers 602. Those two preliminary lower gate spacers 602 may be provided on opposing side surfaces of the preliminary lower gate electrode 604, respectively.

The preliminary lower gate electrode 604 may be a single layer or may include multiple layer(s). The preliminary lower gate electrode 604 may include material(s) different from the lower channel region 208. For example, the preliminary lower gate electrode 604 may include semiconductor material(s) (e.g., silicon germanium (SiGe)). The lower gate capping layer 606 may include material(s) different from the preliminary lower gate electrode 604. For example, the lower gate capping layer 606 may include, for example, silicon oxide, silicon oxynitride, silicon nitride, silicon carbonitride and/or a low-k material.

The lower channel region 208 may extend through the preliminary lower gate electrode 604 and the preliminary lower gate spacer 602 in the first direction X and may contact the lower source/drain region 206. Two lower source/drain regions 206 may be provided on (e.g., may contact) opposing side surfaces of the lower channel region 208.

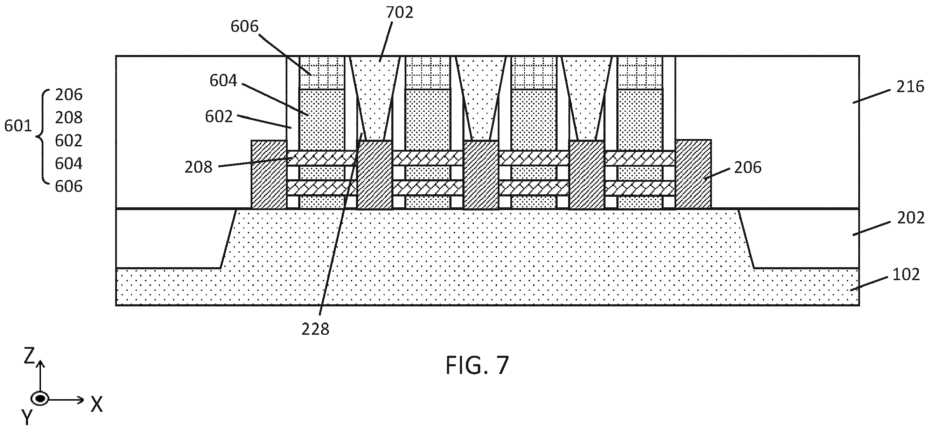

Referring to FIG. 7, a preliminary source/drain contact 702 may be formed between two adjacent preliminary lower transistor structures 601. The preliminary source/drain contact 702 may include a lower surface contacting the lower source/drain region 206. The sixth insulating layer 228 may be provided between the preliminary source/drain contact 702 and the preliminary lower gate spacer 602.

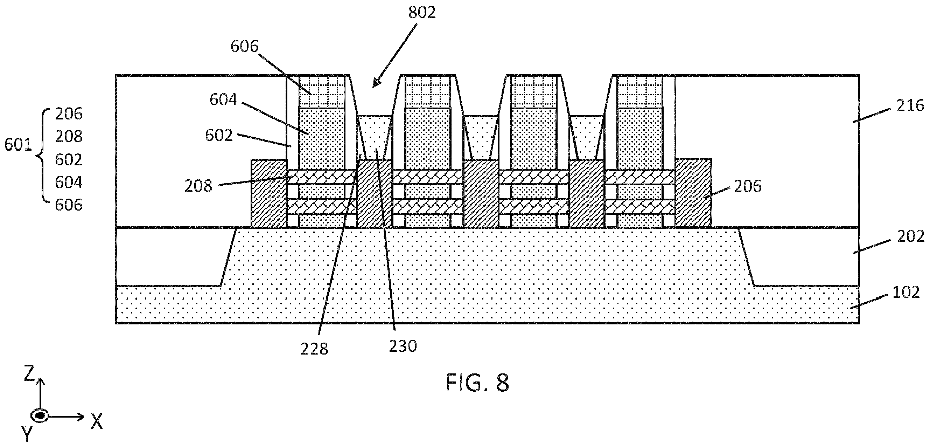

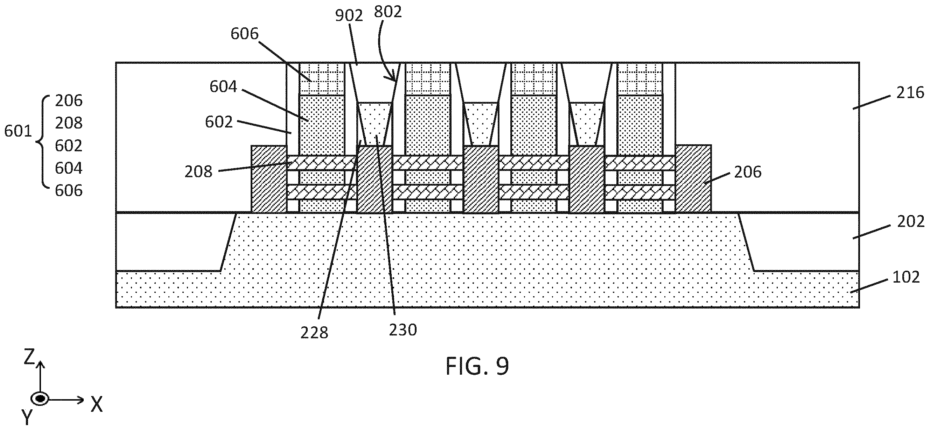

Referring to FIG. 8, a source/drain contact 230 may be formed by removing an upper portion of the preliminary source/drain contact 702. A source/drain contact opening 802 may be formed on the source/drain contact 230. The source/drain contact opening 802 may be defined by an upper surface of the source/drain contact 230 and side surfaces of the preliminary lower gate spacers 602. Referring to FIG. 9, a preliminary seventh insulating layer 902 may be formed in the source/drain contact opening 802. An upper surface of the preliminary seventh insulating layer 902 may be coplanar with both an upper surface of the lower gate capping layer 606 and an upper surface of the first insulating layer 216.

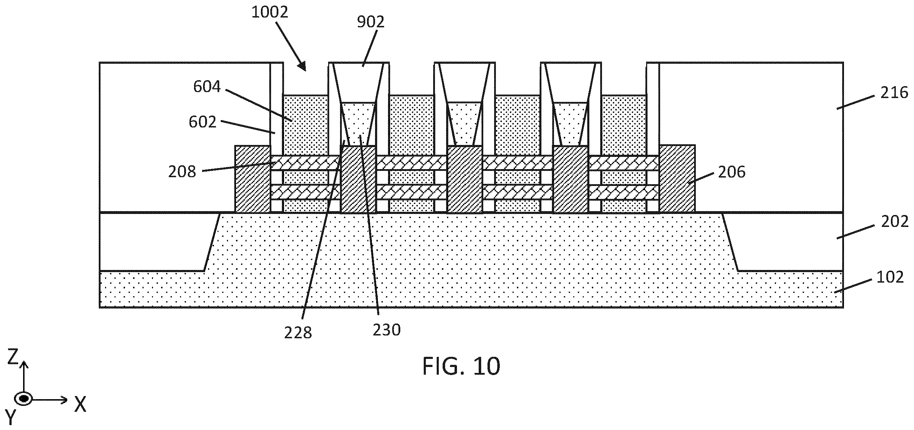

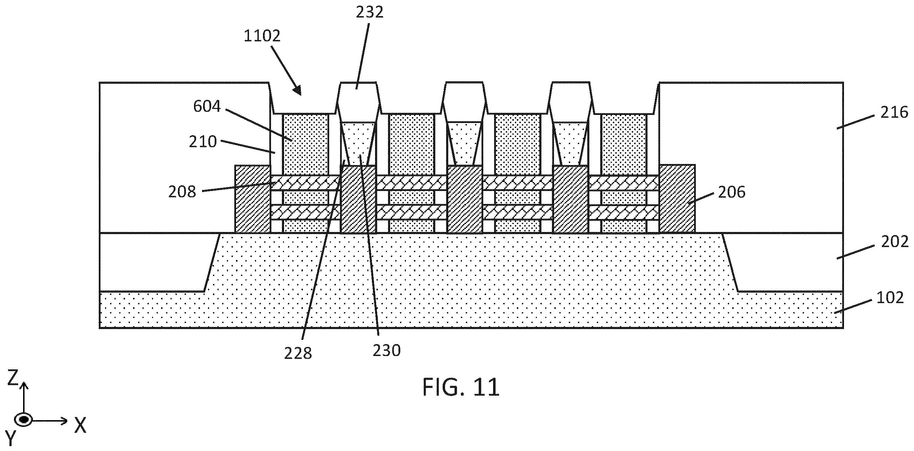

Referring to FIGS. 2, 10 and 11, the method may also include forming a contact opening 1102 on the preliminary lower gate electrode 604 in the first insulating layer 216 (Block 504). A preliminary contact opening 1002 may be formed by removing the lower gate capping layer 606 until the preliminary lower gate electrode 604 is exposed, as illustrated in FIG. 10. The preliminary contact opening 1002 may be defined by an upper surface of the preliminary lower gate electrode 604 and side surfaces of the preliminary lower gate spacers 602. The method may include removing upper portions of the preliminary lower gate spacers 602 to form lower gate spacers 210 and removing a portion of the preliminary seventh insulating layer 902 to form the seventh insulating layer 232 by performing an isotropic etching process (e.g., a wet etching process). The contact opening 1102 may be defined by the upper surface of the preliminary lower gate electrode 604, upper and side surfaces of the lower gate spacers 210, and a side surface of the seventh insulating layer 232. In some embodiments, the contact opening 1102 may have a width in the first direction X increasing with increasing distance from the substrate 102 in the third direction Z, as illustrated in FIG. 11. In this case, a widest width (i.e., the third width W3 in FIG. 2B) of the contact opening 1102 in the first direction X may be wider than a width (i.e., the fourth width W4 in FIG. 2B) of a lower surface of the upper gate electrode 104 in the first direction X.

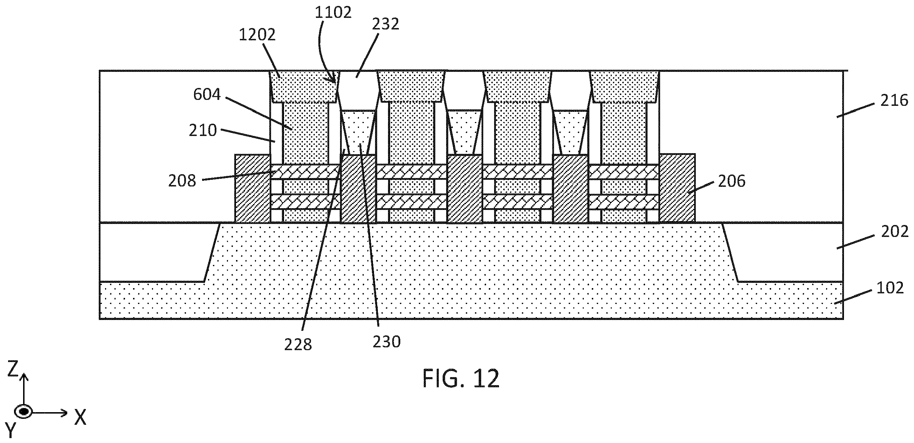

Referring to FIGS. 2 and 12, a preliminary intergate contact 1202 may be formed in the contact opening 1102 (Block 506). In some embodiments, the preliminary intergate contact 1202 may fill the contact opening 1102. A lower surface of the preliminary intergate contact 1202 may contact the upper surface of the preliminary lower gate electrode 604, and an upper surface of the preliminary intergate contact 1202 may be coplanar with the upper surface of the first insulating layer 216.

The preliminary intergate contact 1202 may be a single layer or may include multiple layer(s). The preliminary intergate contact 1202 may include material(s) different from the lower channel region 208 and the upper channel region 212. For example, the preliminary intergate contact 1202 may include semiconductor material(s) (e.g., silicon germanium (SiGe)). The preliminary lower gate electrode 604 and the preliminary intergate contact 1202 may include the same material(s) or different material(s).

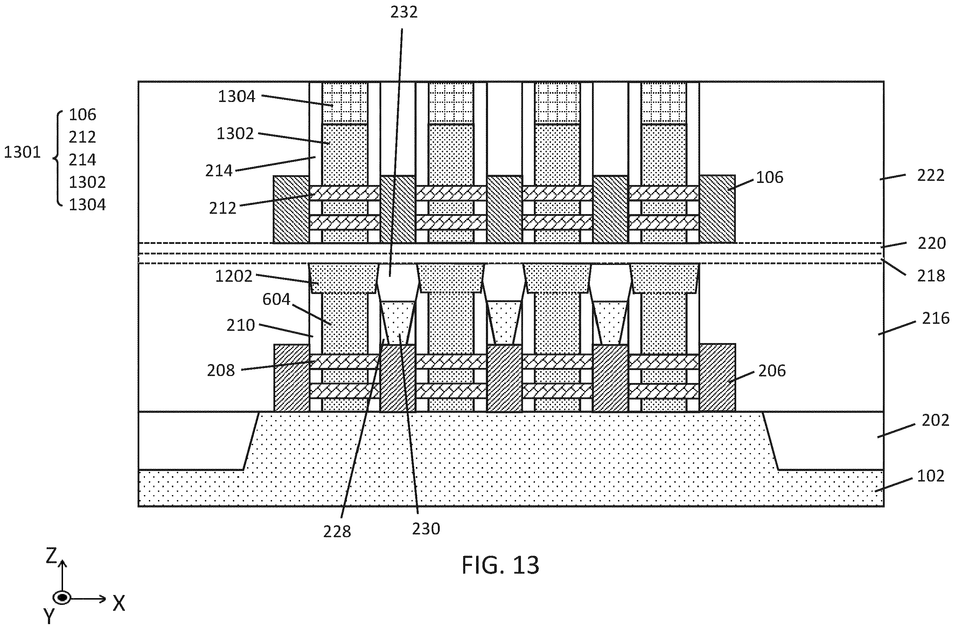

Referring to FIGS. 2 and 13, an intergate insulator including a second insulating layer 218 and a third insulating layer 220 may be formed on the preliminary intergate contact 1202 (Block 508).

Referring to FIG. 13, a preliminary upper transistor structure 1301 may be formed on the third insulating layer 220. The preliminary upper transistor structure 1301 may include an upper channel region 212, an upper gate spacer 214 on the upper channel region 212, a preliminary upper gate electrode 1302 on the upper channel region 212, an upper gate capping layer 1304 on the preliminary upper gate electrode 1302, and an upper source/drain region 106 adjacent to a side surface of the preliminary upper gate electrode 1302. The preliminary upper transistor structure 1301 may include two upper gate spacers 214 that are spaced apart from each other in the first direction X, and both the preliminary upper gate electrode 1302 and the upper gate capping layer 1304 may be between those two upper gate spacers 214. Those upper gate spacers 214 may be provided on opposing side surfaces of the preliminary upper gate electrode 1302, respectively.

The preliminary upper gate electrode 1302 may be a single layer or may include multiple layer(s). The preliminary upper gate electrode 1302 may include material(s) different from the upper channel region 212. For example, the preliminary upper gate electrode 1302 may include semiconductor material(s) (e.g., silicon germanium (SiGe)). The upper gate capping layer 1304 may include material(s) different from the preliminary upper gate electrode 1302. For example, the upper gate capping layer 1304 may include, for example, silicon oxide, silicon oxynitride, silicon nitride, silicon carbonitride and/or a low-k material. The preliminary lower gate electrode 604 and the preliminary upper gate electrode 1302 may include the same material(s) or different material(s), and the lower gate capping layer 606 and the upper gate capping layer 1304 may include the same material(s) or different material(s).

The upper channel region 212 may extend through the preliminary upper gate electrode 1302 and the upper gate spacer 214 in the first direction X and may contact the upper source/drain region 106. Two upper source/drain regions 106 may be provided on (e.g., may contact) opposing side surfaces of the upper channel region 212.

In some embodiments, multiple preliminary upper transistor structures 1301 may be formed on the third insulating layer 220, and the preliminary upper transistor structures 1301 may be spaced apart from each other in a first direction X. The preliminary upper transistor structures 1301 may be provided in the fourth insulating layer 222.

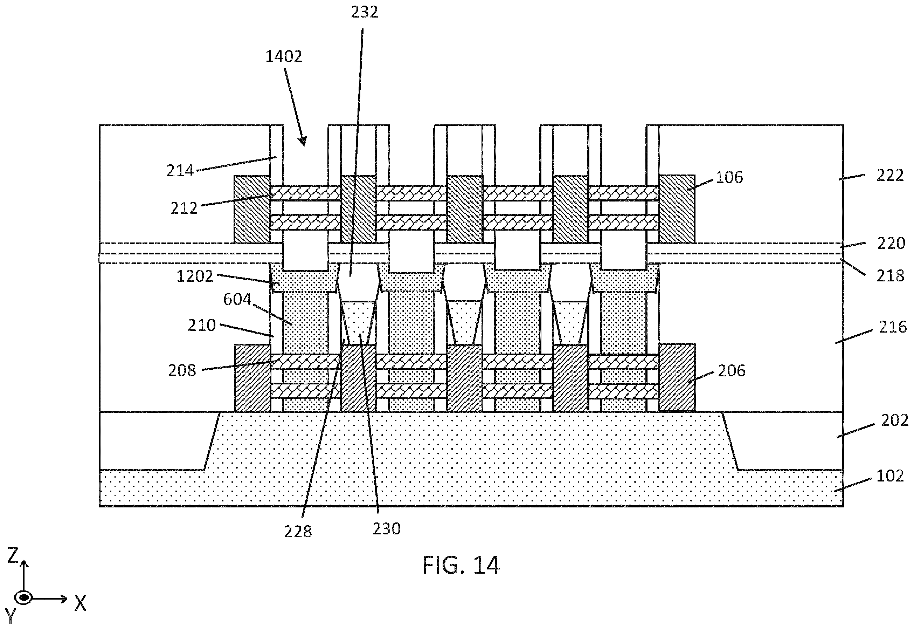

Referring to FIG. 14, the preliminary upper gate electrode 1302 and portions of the second insulating layer 218 and the third insulating layer 220 may be removed, thereby forming an upper gate opening 1402. The upper gate opening 1402 may expose the preliminary intergate contact 1202. In some embodiments, an upper portion of the preliminary intergate contact 1202 may also be removed while forming the upper gate opening 1402 such that a portion of the preliminary intergate contact 1202 may define the upper gate opening 1402, as illustrated in FIG. 14. The preliminary upper gate electrode 1302 and portions of the second insulating layer 218 and the third insulating layer 220 may be removed by etching process(es).

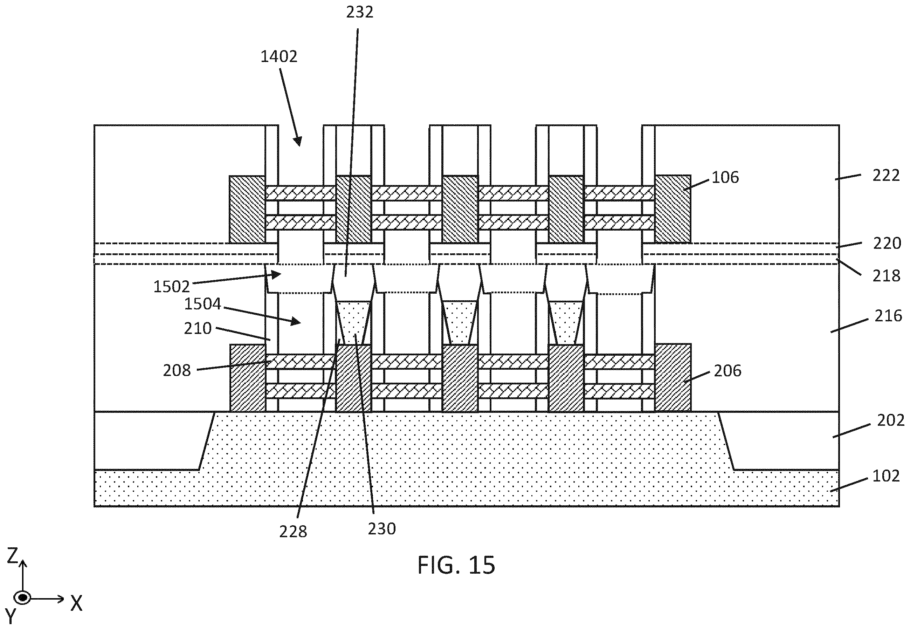

Referring to FIG. 15, the preliminary intergate contact 1202 may be removed to form an intergate contact opening 1502, and the preliminary lower gate electrode 604 may be removed to form a lower gate opening 1504. The upper gate opening 1402, the intergate contact opening 1502 and the lower gate opening 1504 may be connected to each other.

Referring back to FIGS. 2A and 5, the lower gate electrode 204 may be formed in the lower gate opening 1504, thereby forming the lower transistor structure 200 (Block 510). The intergate contact 108 may be formed in the intergate contact opening 1502 after the lower transistor structure 200 is formed (Block 512). After then, the upper gate electrode 104 may be formed in the upper gate opening 1402, thereby forming the upper transistor structure 201 (Block 514). The first upper gate electrode 104 may extend through the intergate insulator that includes the second insulating layer 218 and the third insulating layer 220. In some embodiments, after the lower gate electrode 204 and the intergate contact 108 are formed, an additional intergate insulator may be formed on the intergate contact 108 and then the second upper gate electrode 105 may be formed on the additional intergate insulator. The additional intergate insulator, therefore, may separate the intergate contact 108 from the second upper gate electrode 105.

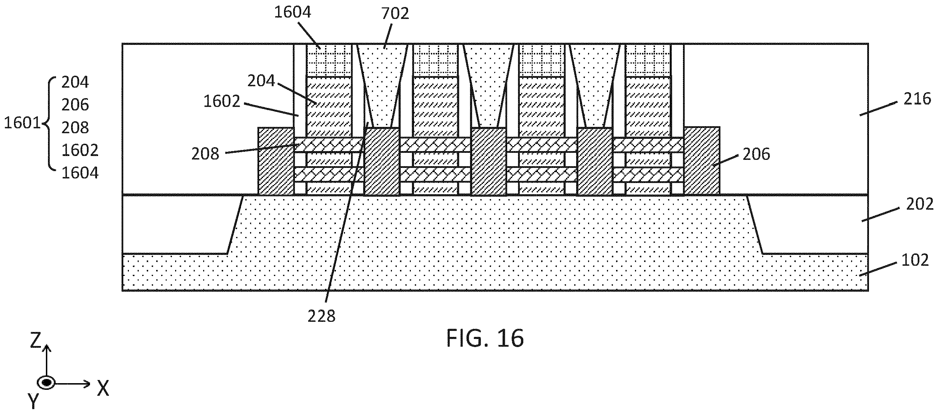

FIGS. 16 through 20 are cross-sectional views illustrating a method of forming an integrated circuit device according to some embodiments.

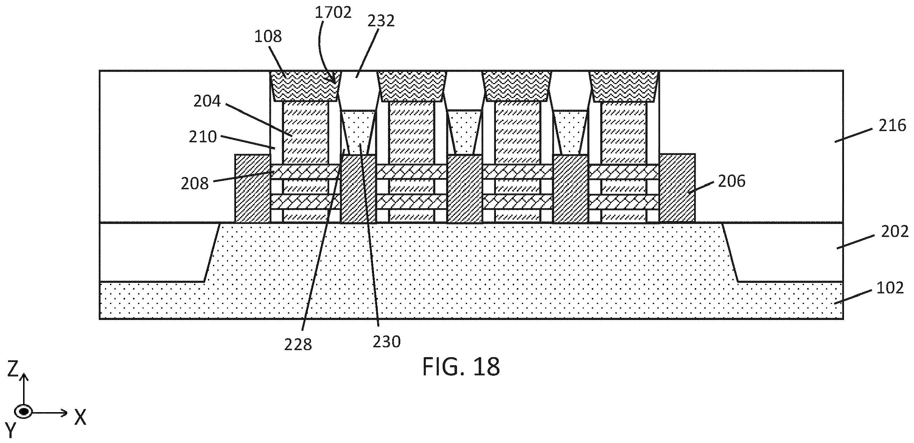

The method illustrated in FIGS. 16 through 20 may be similar to the method illustrated in FIGS. 6 through 15 with the primary difference being that the processes described with reference to Block 510 and Block 512 in FIG. 5 are omitted. According to the method illustrated in FIGS. 16 through 20, a preliminary lower transistor structure 1601 in FIG. 16 may include a lower gate electrode 204 (also referred to as a preliminary lower gate electrode in this method) that may include conductive material(s) and may not be removed during subsequent processes. Therefore, the processes described with reference to Block 510 in FIG. 5 may be omitted. According to the method illustrated in FIGS. 16 through 20, an intergate contact 108 (also referred to as a preliminary intergate contact in this method) in FIG. 18 may include conductive material(s) and may not be removed during subsequent processes. Therefore, the processes described with reference to Block 512 in FIG. 5 may be omitted.

Referring to FIGS. 5 and 16, the method may include forming a preliminary lower transistor structure 1601 and a first insulating layer 216 on a substrate 102 (Block 502). In some embodiments, multiple preliminary lower transistor structures 1601 may be formed on a portion of the substrate 102 defined by a device isolation layer 202, as illustrated in FIG. 16. The preliminary lower transistor structures 1601 may be spaced apart from each other in a first direction X. The preliminary lower transistor structure 1601 may be provided in the first insulating layer 216.

The preliminary lower transistor structure 1601 may include a lower channel region 208, a preliminary lower gate spacer 1602 on the lower channel region 208, a lower gate electrode 204 on the lower channel region 208, a lower gate capping layer 1604 on the lower gate electrode 204, and a lower source/drain region 206 adjacent to a side surface of the lower gate electrode 204. The preliminary lower transistor structure 1601 may include two preliminary lower gate spacers 1602 that are spaced apart from each other in the first direction X, and both the lower gate electrode 204 and the lower gate capping layer 1604 may be provided between those two preliminary lower gate spacers 1602. Those two preliminary lower gate spacers 1602 may be provided on opposing side surfaces of the lower gate electrode 204, respectively.

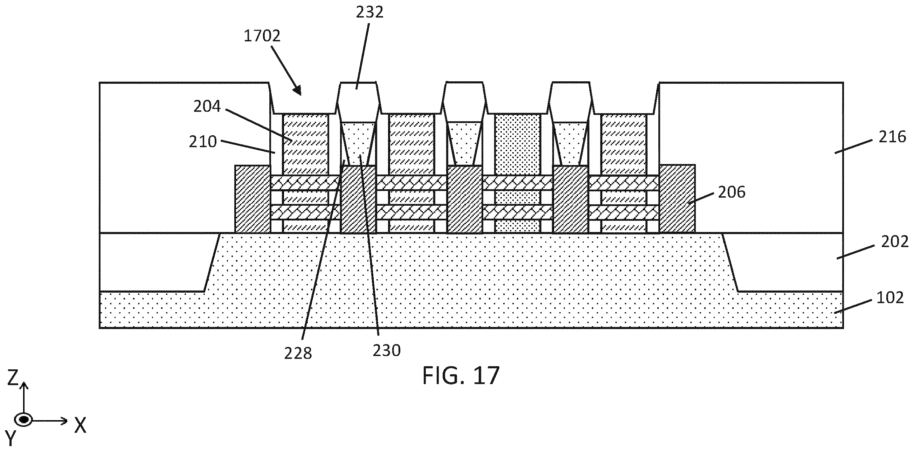

Referring to FIGS. 5 and 17, processes the same as or similar to those described with reference to FIGS. 8 through 11 may be performed to form a contact opening 1702 on the lower gate electrode 204 (Block 504). The contact opening 1702 may be defined by the upper surface of the lower gate electrode 204, upper and side surfaces of the lower gate spacers 210, and a side surface of the seventh insulating layer 232. In some embodiments, the contact opening 1702 may have a width in the first direction X increasing with increasing distance from the substrate 102 in the third direction Z, as illustrated in FIG. 17. In this case, a widest width (i.e., the third width W3 in FIG. 2B) of the contact opening 1702 in the first direction X may be wider than a width (i.e., the fourth width W4 in FIG. 2B) of a lower surface of the upper gate electrode 104 in the first direction X.

Referring to FIGS. 5 and 18, an intergate contact 108 may be formed in the contact opening 1702 (Block 506). In some embodiments, the intergate contact 108 may fill the contact opening 1702. A lower surface of the intergate contact 108 may contact the upper surface of the lower gate electrode 204, and an upper surface of the intergate contact 108 may be coplanar with the upper surface of the first insulating layer 216.

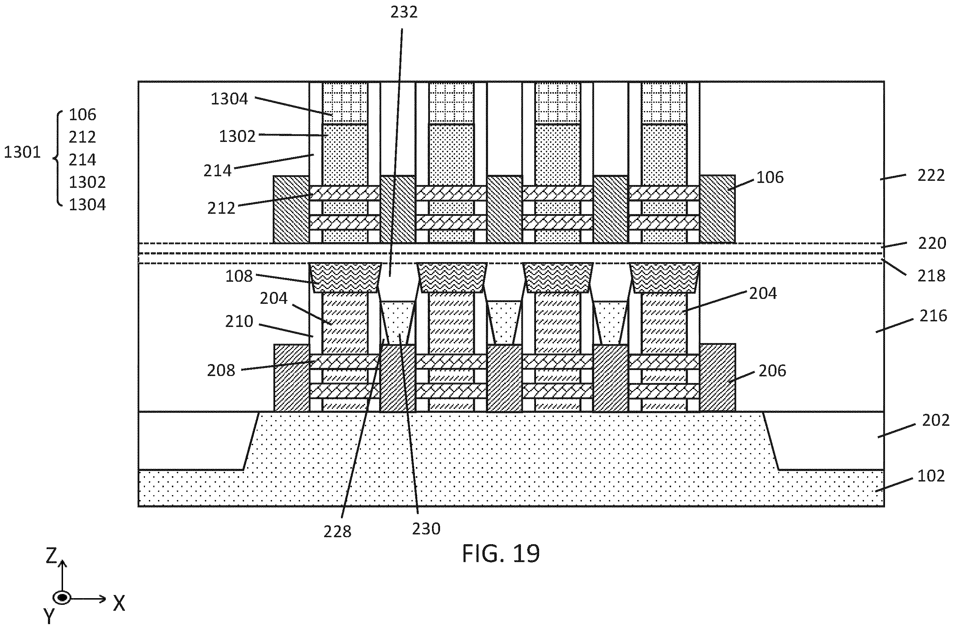

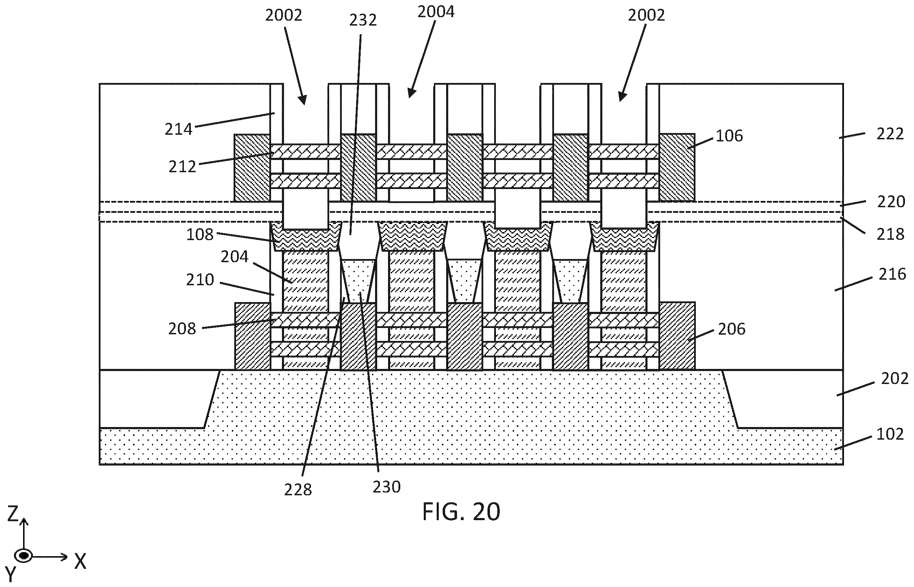

Referring to FIG. 19, a preliminary upper transistor structure 1301 may be formed on the third insulating layer 220. Referring to FIG. 20, the preliminary upper gate electrode 1302 and portions of the second insulating layer 218 and the third insulating layer 220 may be removed, thereby forming a first upper gate opening 2002. The first upper gate opening 2002 may extend through the second insulating layer 218 and the third insulating layer 220 in the third direction Z. The first upper gate opening 2002 may expose the intergate contact 108. An upper portion of the intergate contact 108 may also be removed while forming the first upper gate opening 2002 such that a portion of the intergate contact 108 may define the first upper gate opening 2002, as illustrated in FIG. 20. The preliminary upper gate electrode 1302 and portions of the second insulating layer 218 and the third insulating layer 220 may be removed by etching process(es). The preliminary upper gate electrode 1302 may be removed, thereby forming the second upper gate opening 2004 that exposes an upper surface of the third insulating layer 220.

Referring back to FIGS. 2A and 5, the first upper gate electrode 104 and the second upper gate electrode 105 may be formed, respectively, in the first and second upper gate openings 2002 and 2004, thereby forming the upper transistor structure 201 (Block 514).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing. Although an element is illustrated as a single layer in the drawings, that element may include multiple layers.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.
The above-disclosed subject matter is to be considered illustrative, and not restrictive, and the invention is intended to cover all such modifications, enhancements, and other embodiments, which fall within the scope of the appended claims.

## Claims

1. An integrated circuit device comprising:
an upper transistor structure on a substrate, the upper transistor structure comprising an upper channel region and an upper gate electrode on the upper channel region;
a lower transistor structure between the substrate and the upper transistor structure, the lower transistor structure comprising a lower channel region and a lower gate electrode on the lower channel region; and
an intergate contact between the lower gate electrode and the upper gate electrode,
wherein the lower gate electrode is electrically connected to the upper gate electrode through the intergate contact, and
a portion of a lower surface of the intergate contact protrudes beyond a side surface of the lower gate electrode.

2. The integrated circuit device of Claim 1, wherein the lower channel region and the upper channel region are spaced apart from each other in a vertical direction, and
the portion of the lower surface of the intergate contact protrudes beyond the side surface of the lower gate electrode in a horizontal direction.

3. The integrated circuit device of Claim 1 or 2, wherein the intergate contact is in contact with both the upper gate electrode and the lower gate electrode.

4. The integrated circuit device of any one of Claims 1 to 3, wherein an upper surface of the lower gate electrode has a first width that is narrower than a second width of the lower surface of the intergate contact.

5. The integrated circuit device of any one of Claims 1 to 4, wherein an upper surface of the intergate contact has a third width that is wider than a fourth width of a lower surface of the upper gate electrode.

6. The integrated circuit device of Claim 5, wherein the third width is wider than the second width.

7. The integrated circuit device of any one of Claims 1 to 6, wherein a width of the intergate contact increases with increasing distance from the substrate.

8. The integrated circuit device of any one of Claims 1 to 7, wherein the lower transistor structure further comprises a lower gate spacer on the side surface of the lower gate electrode, and
wherein the portion of the lower surface of the intergate contact is in contact with the lower gate spacer.

9. The integrated circuit device of any one of Claims 1 to 8, wherein the lower channel region and the upper channel region are spaced apart from each other in a vertical direction,
the lower transistor structure further comprises a lower gate spacer on the side surface of the lower gate electrode, and the upper transistor structure further comprises an upper gate spacer on a side surface of the upper gate electrode, and
the side surface of the lower gate electrode and the side surface of the upper gate electrode face the same direction and are offset from each other in a horizontal direction.

10. The integrated circuit device of any one of Claims 1 to 9, wherein the intergate contact comprises a material different from the upper gate electrode or the lower gate electrode.

11. The integrated circuit device of any one of Claims 1 to 10, wherein the upper channel region overlaps the lower channel region.

12. A method of forming an integrated circuit device, the method comprising:
forming a preliminary lower transistor structure on a substrate, the preliminary lower transistor structure comprises:
a lower channel region;
two preliminary lower gate spacers that are spaced apart from each other in a horizontal direction and are on the lower channel region;
a preliminary lower gate electrode that is between the two preliminary lower gate spacers and is on the lower channel region; and
a lower gate capping layer that is between the two preliminary lower gate spacers and is on the preliminary lower gate electrode;
forming a first insulating layer on the substrate, wherein the preliminary lower transistor structure is in the first insulating layer;
removing the lower gate capping layer and respective upper portions of the two preliminary lower gate spacers, thereby forming a contact opening in the first insulating layer on the preliminary lower gate electrode;
forming a preliminary intergate contact in the contact opening;
forming an intergate insulator on the preliminary intergate contact; and
forming an upper transistor structure on the intergate insulator, the upper transistor structure comprising an upper channel region and an upper gate electrode on the upper channel region,
wherein the upper gate electrode extends through the intergate insulator.

13. The method of Claim 12, wherein the contact opening has a width in the horizontal direction increasing with increasing distance from the substrate.

14. The method of Claim 12 or 13, wherein a widest width of the contact opening in the horizontal direction is wider than a width of a lower surface of the upper gate electrode in the horizontal direction.

15. The method of any one of Claims 12 to 14, wherein forming the upper transistor structure comprises:
forming a preliminary upper transistor structure on the intergate insulator, wherein the preliminary upper transistor structure comprises the upper channel region, two preliminary upper gate spacers that are spaced apart from each other in the horizontal direction and are on the upper channel region and a preliminary upper gate electrode between the two preliminary upper gate spacers;
removing the preliminary upper gate electrode and a portion of the intergate insulator, thereby forming an upper gate opening that extends through the intergate insulator and is defined by the two preliminary upper gate spacers, wherein the upper gate opening exposes the preliminary intergate contact; and
forming the upper gate electrode in the upper gate opening.
